(19) Europäisches Patentamt
European Patent Office
Office européen des brevets

(11) **EP 4 567 549 A1**

(12) **EUROPEAN PATENT APPLICATION**

(43) Date of publication:
**11.06.2025 Bulletin 2025/24**

(21) Application number: **24217050.4**

(22) Date of filing: **03.12.2024**

(51) International Patent Classification (IPC):
**G06F 1/12** (2006.01)     **G01H 1/00** (2006.01)
**G04G 7/00** (2006.01)

(52) Cooperative Patent Classification (CPC):
**G06F 1/12; B06B 1/00; G01H 3/08; G04G 7/023; G04G 7/026**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.12.2023 JP 2023205614**

(71) Applicant: **Yokogawa Electric Corporation Tokyo 180-8750 (JP)**

(72) Inventors:
• **OGAWA, Hiromitsu**
  **Musashino-shi, Tokyo 180-8750 (JP)**
• **ANNEN, Masato**
  **Musashino-shi, Tokyo 180-8750 (JP)**
• **KONADA, Soichiro**
  **Musashino-shi, Tokyo 180-8750 (JP)**

(74) Representative: **Winter, Brandl - Partnerschaft mbB**
**Alois-Steinecker-Straße 22**
**85354 Freising (DE)**

(54) **DETECTION APPARATUS, TIME SYNCHRONIZATION METHOD, NON- TRANSITORY COMPUTER READABLE RECORDING MEDIUM, AND DETECTION SYSTEM**

(57)     A detection apparatus (10) according to one embodiment includes an internal clock, an oscillator unit (11) that generates oscillation every time a temporal condition is met, an oscillation receiver unit (12) that detects oscillation, a measurement unit (142) that measures a time from when the oscillator unit (11) generates the oscillation to when the oscillation receiver unit (12) detects the oscillation, a determination unit (141) that determines a mode based on whether a time that is measured by the measurement unit (142) is longer than a predetermined interval time, and a correction unit (143) that determines whether to perform correction of deviation of the internal clock based on a reference time when it is determined that the mode is a specific mode, and corrects the internal clock when determining that the correction is performed.

FIG.1

**Description**

BACKGROUND

The present invention relates to a detection apparatus, a time synchronization method, a non-transitory computer readable recording medium, and a detection system.

A method of identifying a position of a source of oscillation by comparing sensor values, which are related to oscillation and which are measured by a plurality of sensors, based on measurement times is known. Meanwhile, the oscillation includes sound.

In addition, Japanese Unexamined Patent Application Publication No. 2017-96651 describes a method of causing two sensors to output oscillation, causing each of the sensors to measure the oscillation that is output by the other sensor, and synchronizing times of internal clocks of the respective sensors.

However, the conventional technology has a problem in that, in some cases, it may be difficult to synchronize times while taking into account positional relationship among a plurality of sensors.

For example, in some cases, the plurality of sensors may be arranged differently before and after installation. In this case, the positional relationship among the sensors differs before and after the installation. However, in the conventional technology, the positional relationship among the sensors, which depends on whether the sensors are not installed or the sensors are installed, is not taken into account.

For example, even when time deviation is detected among the sensors by the method described in Japanese Unexamined Patent Application Publication No. 2017-96651, it is difficult to determine whether the deviation is caused by time deviation of the internal clocks themselves or by a change in a propagation time due to a change in the positional relationship.

When the time deviation occurs in the internal clocks, it is needed to correct the internal clocks to synchronize times. In contrast, when the time deviation is detected due to a change in the positional relationship among the sensors, it is not needed to correct the internal clocks.

According to one aspect, an object of the present invention is to synchronize times while taking into account a positional relationship among a plurality of sensors.

SUMMARY

According to an aspect of an embodiment, a detection apparatus includes: an internal clock; an oscillator unit that generates oscillation every time a temporal condition is met; an oscillation receiver unit that detects oscillation; a measurement unit that measures a time from when the oscillator unit generates the oscillation to when the oscillation receiver unit detects the oscillation; a determination unit that determines a mode based on whether the time that is measured by the measurement unit is longer than a predetermined interval time; and a correction unit that determines whether to perform correction of deviation of the internal clock based on a reference time when it is determined that the mode is a specific mode, and corrects the internal clock when determining that the correction is performed.

According to an aspect of an embodiment, a time synchronization method that is implemented by a detection apparatus including: an internal clock; an oscillator unit that generates oscillation every time a temporal condition is met; and an oscillation receiver unit that detects oscillation, the time synchronization method includes: measuring a time from when the oscillator unit generates the oscillation to when the oscillation receiver unit detects the oscillation; determining a mode based on whether the time that is measured at the measuring is longer than a predetermined interval time; determining whether to perform correction of deviation of the internal clock when it is determined that the mode is a specific mode; and correcting the internal clock when determining that the correction is performed.

According to an aspect of an embodiment, a time synchronization program that causes a detection apparatus including: an internal clock; an oscillator unit that generates oscillation every time a temporal condition is met; and an oscillation receiver unit that detects oscillation, to perform a process comprising: measuring a time from when the oscillator unit generates the oscillation to when the oscillation receiver unit detects the oscillation; determining a mode based on whether the time that is measured at the measuring is longer than a predetermined interval time; determining whether to perform correction of deviation of the internal clock when it is determined that the mode is a specific mode; and correcting the internal clock when determining that the correction is performed.

According to an aspect of an embodiment, a detection system includes: a first detection apparatus that includes a first internal clock; and a second detection apparatus that includes a second internal clock, wherein the first detection apparatus further includes: a first oscillator unit that generates oscillation every time a temporal condition is met; a first oscillation receiver unit that detects oscillation that is generated by the second detection apparatus; a measurement unit that measures a time from when the first oscillator unit generates the oscillation to when the first oscillation receiver unit detects the oscillation; a determination unit that determines a mode based on whether the time that is measured by the measurement unit is longer than a predetermined interval time; and a correction unit that determines whether to perform correction of deviation between the first internal clock and the second internal clock based on a reference time when it is determined that the mode is a specific mode, and corrects one of the first internal clock and the second internal clock when determining that the correction is performed, and the second detection apparatus further includes: a second oscillator unit that generates oscillation every time a temporal condition is met.

BRIEF DESCRIPTION OF THE DRAWINGS

FIG. 1 is a diagram illustrating a configuration example of a detection system according to a first embodiment;
FIG. 2 is a diagram illustrating a configuration example of a detection apparatus according to the first embodiment;
FIG. 3 is a diagram illustrating an example of arrangement of detection apparatuses;
FIG. 4 is a diagram illustrating an example of operation of the detection system;
FIG. 5 is a diagram illustrating an example of arrangement of the detection apparatuses;
FIG. 6 is a diagram illustrating an example of operation of the detection system;
FIG. 7 is a diagram illustrating an example of arrangement of the detection apparatuses;
FIG. 8 is a diagram illustrating an example of operation of the detection system;
FIG. 9 is a diagram illustrating an example of arrangement of the detection apparatuses;
FIG. 10 is a diagram illustrating an example of operation of the detection system;
FIG. 11 is a diagram illustrating an example of arrangement of the detection apparatuses;
FIG. 12 is a diagram illustrating an example of operation of the detection system;
FIG. 13 is a flowchart illustrating the flow of a process performed by the detection apparatus according to the first embodiment;
FIG. 14 is a diagram for explaining a first example;
FIG. 15 is a diagram for explaining a second example;
FIG. 16 is a diagram for explaining a third example; and
FIG. 17 is a diagram for explaining a hardware configuration example.

DESCRIPTION OF EMBODIMENTS

Embodiments of a detection apparatus, a time synchronization method, a time synchronization program, and a detection system disclosed in the present application will be described in detail below based on the drawings. The invention in the present application is not limited by the embodiments described below. Further, the same elements are denoted by the same reference symbols, and repeated explanation will be omitted appropriately. Furthermore, the embodiments may be combined appropriately as long as no contradiction is derived.

First Embodiment

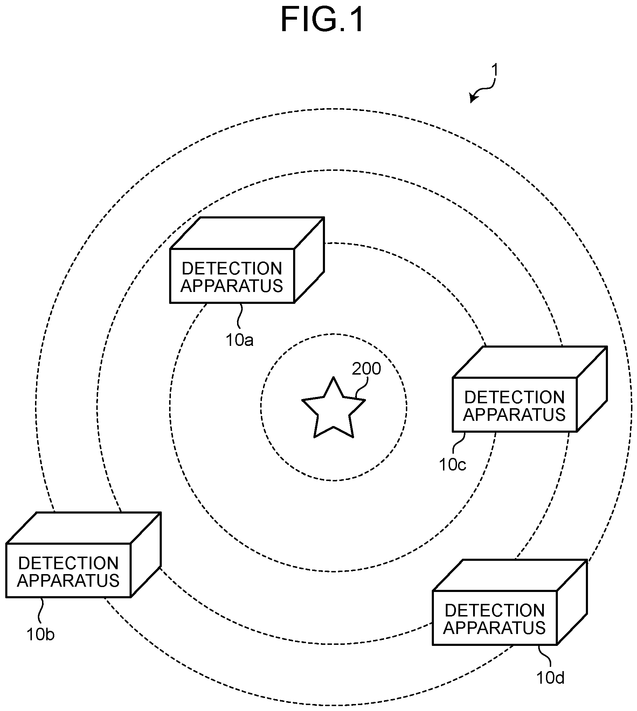

A configuration of a detection system according to a first embodiment will be described below with reference to FIG. 1. FIG. 1 is a diagram illustrating a configuration example of the detection system according to the first embodiment.
As illustrated in FIG. 1, a detection system 1 includes a detection apparatus 10a, a detection apparatus 10b, a detection apparatus 10c, and a detection apparatus 10d. In the explanation below, in some cases, each of the detection apparatuses may be described as a detection apparatus 10 instead of distinguishing one from another.
The detection system 1 is a system for detecting abnormality of a device. Examples of the device include a motor and a pump that are included in a plant. The device generates oscillation during operation. For example, when the device is physically damaged, a waveform (a frequency or the like) of oscillation that is generated by the device may change.
The detection apparatus 10 is a sensor that detects oscillation with a changed waveform as abnormal oscillation. The detection system 1 is able to identify a source of abnormal oscillation based on a time at which each of the detection apparatuses 10 detects the abnormal oscillation, a propagation situation of the oscillation, a magnitude (including sound pressure) of the oscillation, or the like. For example, the detection system 1 identifies that the source of the abnormal oscillation is located at a position 200 in FIG. 1.
In this case, when an internal clock of the detection apparatus 10 deviates, the time at which the abnormal oscillation is detected is incorrect. As a result, it becomes difficult for the detection system 1 to identify the source of the abnormal oscillation with high accuracy. Meanwhile, the deviation of the internal clock includes not only absolute deviation from an accurate time, but also relative deviation among the apparatuses. The detection system 1 is able to identify the source of the abnormal oscillation as long as relative deviation of the internal clocks does not occur among the detection apparatuses 10.

Further, it is sufficient for the detection system 1 to include the plurality of detection apparatuses 10. The number of the detection apparatuses 10 included in the detection system 1 is not limited to the number illustrated in FIG. 1.

The detection apparatus 10 generates oscillation. Further, the detection apparatus 10 detects oscillation. Meanwhile, it is assumed that the oscillation includes sound. Furthermore, an oscillation transmission medium may be any of a gas, a liquid, and a solid. An installation location of the detection apparatus 10 may be in the air or may be under water.

The detection apparatus 10 determines whether or not the internal clock deviates based on a comparison result between a time at which oscillation is generated and a time at which the oscillation is detected, and appropriately corrects the internal clock depending on a determination result.

Meanwhile, the detection apparatus 10 may use, for time synchronization, a mechanism that detects oscillation for detecting abnormality of a device. In contrast, the detection apparatus 10 may be a sensor that detects abnormality of a device from a different kind of information, such as an image or pressure, instead of oscillation. In this case, in the detection apparatus 10, a mechanism for detecting oscillation for the purpose of time synchronization is arranged separately.

Meanwhile, deviation of the internal clock may be determined by using a Global Positioning System (GPS) or the Internet. However, the GPS and the Internet are not available in an environment in which radio waves are blocked. In contrast, the detection apparatus 10 of the present embodiment is able to determine deviation of the internal clock even in an environment in which the GPS and the Internet are not available.

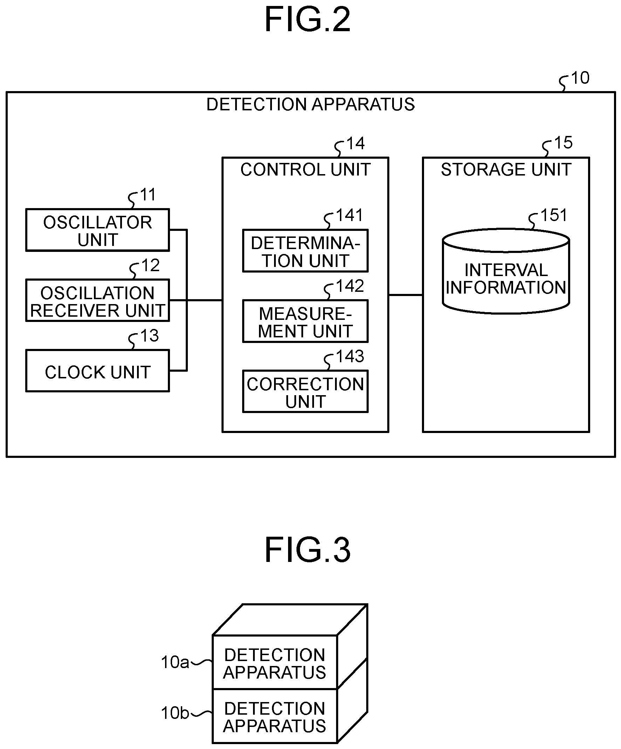

A configuration of the detection apparatus 10 will be described with reference to FIG. 2. FIG. 2 is a diagram illustrating a configuration example of the detection apparatus according to the first embodiment.

As illustrated in FIG. 2, the detection apparatus 10 includes an oscillator unit 11, an oscillation receiver unit 12, a clock unit 13, a control unit 14, and a storage unit 15. Further, the detection apparatus 10 may include a communication unit (for example, a network interface card) for performing data communication in a wired or wireless manner.

The oscillator unit 11 is a device that generates oscillation (including sound) at a designated frequency. For example, the oscillator unit 11 is a vibrator or a speaker.

The oscillation receiver unit 12 is a device that detects oscillation (including sound). For example, the oscillation receiver unit 12 is a vibration sensor or a microphone.

The clock unit 13 is a device that functions as an internal clock. For example, the clock unit 13 includes a crystal oscillator and an oscillation circuit. The clock unit 13 outputs a current time.

The control unit 14 is a processing unit that controls the entire detection apparatus 10. The control unit 14 is an arithmetic device, such as a Central Processing Unit (CPU) or a microcomputer, which includes a processor. The control unit 14 includes a determination unit 141, a measurement unit 142, and a correction unit 143.

The determination unit 141 determines a mode based on whether or not a time that is measured by the measurement unit 142 is longer than a predetermined interval time. The determination unit 141 determines whether a mode of the detection apparatus 10 is a pre-installation mode or a post-installation mode. The measurement unit 142 measures a time from when the oscillator unit 11 generates oscillation to when the oscillation receiver unit 12 detects the oscillation. When it is determined that the mode is a specific mode (for example, the post-installation mode to be described later), the correction unit 143 determines whether to perform correction of deviation of the internal clock based on a reference time, and corrects the internal clock as needed.

In this manner, the detection apparatus 10 has a plurality of modes that correspond to positional relationships with the other detection apparatuses 10. By changing a process related to the correction of deviation of the internal clock depending on the modes, the detection apparatus 10 is able to perform time synchronization while taking into account the positional relationship among the plurality of sensors.

The storage unit 15 stores therein various kinds of data, various kinds of programs that are executed by the control unit 14, and the like. For example, the storage unit 15 is a storage device, such as a Hard Disk Drive (HDD), a Solid State Dive (SSD), or a flash memory. The storage unit 15 stores therein various kinds of data that are generated by a process that is performed by the detection apparatus 10, such as data that is obtained while the control unit 14 executes various kinds of processes and a processing result that is obtained by execution of various kinds of processes.

The storage unit stores therein interval information 151. The interval information 151 is a predetermined interval time that is set in advance. Details of the interval time will be described later.

A plurality of arrangement examples of the detection apparatuses 10 and examples of operation of the detection system 1 in each of the arrangement examples will be described below.

First arrangement example: two detections apparatuses are arranged close to each other

FIG. 3 is a diagram illustrating an arrangement example of the detection apparatuses. As illustrated in FIG. 3, before start of operation of the detection system 1, the detection apparatus 10a and the detection apparatus 10b are arranged close to each other. Here, close arrangement indicates that a distance between the apparatuses is adequately small and includes a distance of zero between the apparatuses, that is, close contact between the apparatuses.

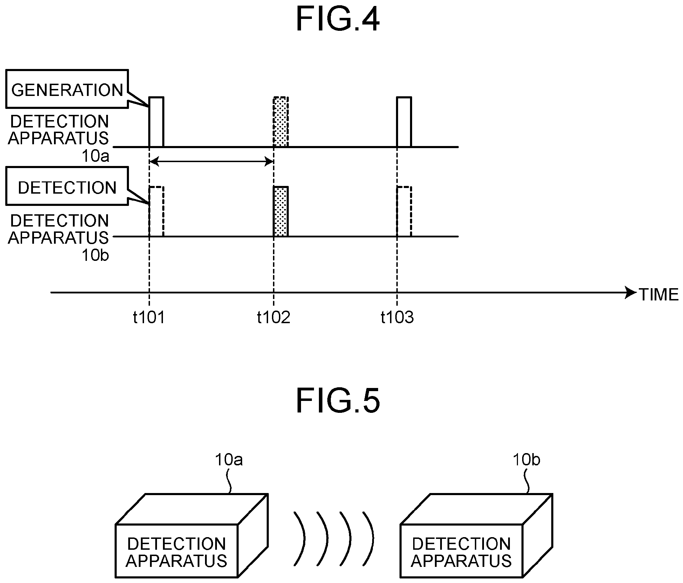

FIG. 4 is a diagram illustrating an example of operation of the detection system corresponding to the arrangement example illustrated in FIG. 3. In each of the drawings including FIG. 4 that illustrates an example of the operation, solid line rectangles and dashed line rectangles are arranged on a straight line that represents a time series corresponding to each of the detection apparatuses 10. The solid line rectangle indicates generation of oscillation. Further, the dashed line rectangle indicates detection of oscillation. Furthermore, a symbol composed of t and numerals represents a time. Moreover, a subtraction, such as txxx - tyyy, represents a duration from a time txxx to a time tyyy (here, xxx and yyy are numerals).

The detection apparatus 10a and the detection apparatus 10b generate oscillation every time a temporal condition that is a condition regarding a time is met. The temporal condition may be that a cycle time elapses since detection of oscillation by the detection apparatus, may be that a cycle time that is determined based on a time that is set in advance elapses, or may be that a time that is set by a timer comes. In the present embodiment, the detection apparatus 10a and the detection apparatus 10b generate oscillation per cycle time that is determined in advance. The cycle time may be a short time, such as a few seconds (for example, two seconds or three seconds), or may be a long time, such as several tens of minutes or more (for example, 30 minutes or 60 minutes). In FIG. 4, the cycle time is set to two seconds. Further, it is assumed that an interval time of one second is set between a time at which the detection apparatus 10a generates oscillation and a time at which the detection apparatus 10b generates oscillation.

In this case, operation is repeated such that the detection apparatus 10b generates oscillation one second after the detection apparatus 10a generates oscillation, and the detection apparatus 10a generates oscillation one second after the detection apparatus 10c generates oscillation.

As illustrated in FIG. 4, the detection apparatus 10a generates oscillation at t101. Further, the detection apparatus 10b detects, at t101, the oscillation that is generated by the detection apparatus 10a. Furthermore, the detection apparatus 10b generates oscillation at t102. Moreover, the detection apparatus 10a detects, at t102, the oscillation that is generated by the detection apparatus 10b at t102.

The detection apparatus 10a measures t102 - t101. As illustrated in FIG. 4, when t102 - t101 is equal to the interval time, the detection apparatus 10a determines that the mode is the pre-installation mode.

Meanwhile, at the start of operation, a user has the detection apparatus 10a and the detection apparatus 10b in his/her hand, and the detection apparatus 10a and the detection apparatus 10b are arranged close to each other and it is confirmed that the apparatuses are in the pre-installation modes. Thereafter, the detection apparatus 10a and the detection apparatus 10b are arranged separately from each other (for example, arranged at positions distant from each other in the plant), and enter the post-installation modes. At this time, the user may adjust the internal clocks.

When t102 - t101 is shorter than the interval time, the internal clock of the detection apparatus 10a or the detection apparatus 10b may be inaccurate and adjustment or the like is needed.

Further, the detection apparatus 10a may be notified of a current mode by the user or the like. When the detection apparatus 10a is notified that the current mode is the pre-installation mode and when t102 - t101 is longer than the interval time, the internal clock of the detection apparatus 10a or the detection apparatus 10b may be inaccurate and adjustment or the like is needed.

Here, in reality, even when the detection apparatus 10a and the detection apparatus 10b are arranged close to each other, it takes a time for the oscillation to propagate inside the apparatuses (hereinafter, a minimum propagation time). In the explanation above, it is assumed that the detection apparatus 10a ignores the minimum propagation time; however, the detection apparatus 10a may determine the mode while taking into account the minimum propagation time.

The minimum propagation time is denoted by $\varepsilon$ below. For example, the detection apparatus 10a determines the mode depending on whether t102 - t101 - $\varepsilon$ is longer than or shorter than the interval time. Furthermore, it may be possible to set an interval time while taking into account the minimum propagation time in advance.

It is assumed that the oscillation is sound that propagates through the air, and temperature is 20°C. In this case, a sound speed is 343.59 (m/s) = 34.359 (cm/s). Further, it is assumed that a thickness of a layer of air through which the sound propagates between the detection apparatus 10a and the detection apparatus 10b that are arranged close to each other is 1 centimeter (cm). Therefore, a minimum propagation speed $\varepsilon$ is represented by Expression (1) below. However, the minimum propagation speed $\varepsilon$ varies depending on shapes, a degree of closeness, or the like of the detection apparatuses 10.

$$\varepsilon = 1 \text{ (cm)} / 34.359 \text{ (cm/s)} = 2.91 \times 10^{-5} \approx 30 \text{ μs}$$

$$(1)$$

In the description below, it is assumed that the detection apparatus 10 ignores the minimum propagation time. However, as described above, the detection apparatus 10 may perform a process while taking into account the minimum propagation time.

Meanwhile, when deviation of the internal clock that occurs due to ignorance of the minimum propagation time falls within a certain range that is operationally acceptable, it may be possible to consider that the detection apparatus 10a and the detection apparatus 10b at this time are arranged close to each other. For example, when deviation of the internal clock up to 60 microseconds ($\mu$s) (30 $\mu$s $\times$ 2) is acceptable, and if the apparatuses are arranged such that a thickness of a layer of air through which sound propagates is equal to or smaller than 2 cm (1 cm $\times$ 2), the detection apparatus 10a and the detection apparatus 10b are considered close to each other.

Second arrangement example: two detection apparatuses are separated from each other

FIG. 5 is a diagram illustrating an arrangement example of the detection apparatuses. As illustrated in FIG. 5, at the time of operation of the detection system 1, the detection apparatus 10a and the detection apparatus 10b are arranged separately from each other.

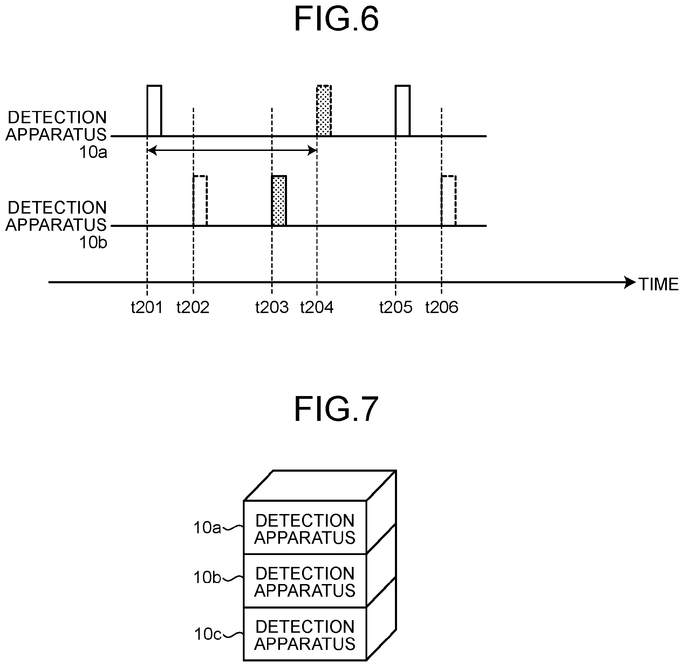

FIG. 6 is a diagram illustrating an example of operation of the detection system corresponding to the arrangement example illustrated in FIG. 5. Similarly to FIG. 4, the cycle time is set to two seconds and the interval time is set to one second. In this case, operation is repeated such that the detection apparatus 10b generates oscillation one second after the detection apparatus 10a generates oscillation, and the detection apparatus 10a generates oscillation one second after the detection apparatus 10b generates oscillation. Meanwhile, when the user does not adjust the internal clock of the detection apparatus, it may be possible to adopt a method in which the detection apparatus 10a generates oscillation, and, after a lapse of a first time (for example, one second) since a time at which the detection apparatus 10b detects the oscillation that is generated by the detection apparatus 10a, the detection apparatus 10b generates oscillation and the detection apparatus 10a detects the oscillation that is generated by the detection apparatus 10b.
As illustrated in FIG. 6, the detection apparatus 10a generates oscillation at t201. Further, the detection apparatus 10b detects, at t202, the oscillation that is generated by the detection apparatus 10a. Furthermore, the detection apparatus 10b generates oscillation at t203. Moreover, the detection apparatus 10a detects, at t204, the oscillation that is generated by the detection apparatus 10b at t203.
The detection apparatus 10a measures t204 - t201. When t204 - t201 is longer than the interval time, the detection apparatus 10a determines that the mode is the post-installation mode. Meanwhile, t204 - t201 is longer than t102 - t101 illustrated in FIG. 4. This is because an oscillation propagation time increases due to separation between the detection apparatus 10a and the detection apparatus 10b.
The detection apparatus 10a stores t204 - t201 as a reference time. Further, the detection apparatus 10a continuously measures a time from generation of the oscillation to detection of the oscillation that is generated by the detection apparatus 10b, compares the measured time with the reference time, and determines whether or not the internal clock of the detection apparatus 10a or the detection apparatus 10b deviates.
When the measured time is different from the reference time, the detection apparatus 10a determines that the internal clock of the detection apparatus 10a or the detection apparatus 10b deviates, and corrects the internal clock of one or both of the apparatuses.

Third arrangement example: three detection apparatuses are arranged close to one another

The arrangement and the operation of the two detection apparatuses 10 as described above may be extended to the three or more detection apparatuses 10.
FIG. 7 is a diagram illustrating an arrangement example of the detection apparatuses. As illustrated in FIG. 7, before operation of the detection system 1, the detection apparatus 10a, the detection apparatus 10b, and the detection apparatus 10c are arranged close to one another.

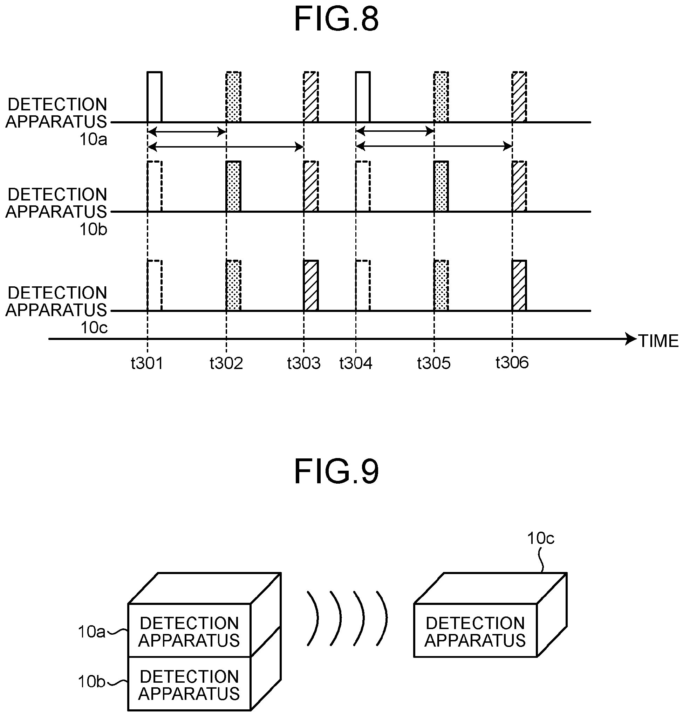

FIG. 8 is a diagram illustrating an example of operation of the detection system corresponding to the arrangement example illustrated in FIG. 7. The cycle time is set to three seconds. Further, the interval time between the detection apparatus 10a and the detection apparatus 10b is set to one second. Furthermore, the interval time between the detection apparatus 10a and the detection apparatus 10c is set to two seconds. In this case, operation is repeated such that the detection apparatus 10b generates oscillation one second after the detection apparatus 10a generates oscillation, the detection apparatus 10c generates oscillation one second after the detection apparatus 10b generates oscillation, and the detection apparatus 10a generates oscillation one second after the detection apparatus 10c generates oscillation.
As illustrated in FIG. 8, the detection apparatus 10a generates oscillation at t301. Further, the detection apparatus 10b and the detection apparatus 10c detect, at t301, the oscillation that is generated by the detection apparatus 10a at t301.
Furthermore, the detection apparatus 10b generates oscillation at t302. Moreover, the detection apparatus 10a and the detection apparatus 10c detect, at t302, the oscillation that is generated by the detection apparatus 10b at t302.
Furthermore, the detection apparatus 10c generates oscillation at t303. Moreover, the detection apparatus 10a and the detection apparatus 10b detect, at t303, the oscillation that is generated by the detection apparatus 10c at t303.

The detection apparatus 10a measures t302 - t301. When t302 - t301 is longer than the interval time with respect to the detection apparatus 10b, the detection apparatus 10a determines that the mode with respect to the detection apparatus 10b is the post-installation mode. When t302 - t301 is equal to the interval time with respect to the detection apparatus 10b, the detection apparatus 10a determines that the mode with respect to the detection apparatus 10b is the pre-installation mode.

The detection apparatus 10a measures t303 - t301. When t303 - t301 is longer than the interval time with respect to the detection apparatus 10c, the detection apparatus 10a determines that the mode with respect to the detection apparatus 10c is the post-installation mode. When t303 - t301 is equal to the interval time with respect to the detection apparatus 10c, the detection apparatus 10a determines that the mode with respect to the detection apparatus 10c is the pre-installation mode.

As described above, the detection apparatus 10a independently determines the mode with respect to each of the detection apparatus 10b and the detection apparatus 10c. In the example illustrated in FIG. 8, the mode between the detection apparatus 10a and the detection apparatus 10b and the mode between the detection apparatus 10a and the detection apparatus 10c are the pre-installation modes.

In this case, the detection apparatus 10a sets a reference time with respect to each of the detection apparatus 10b and the detection apparatus 10c, and determines deviation of the internal clocks based on the respective reference times.

Fourth arrangement: two of three detection apparatuses are arranged close to each other

FIG. 9 is a diagram illustrating an arrangement example of the detection apparatuses. As illustrated in FIG. 9, the detection apparatus 10a and the detection apparatus 10b are arranged close to each other. Further, the detection apparatus 10c is separated from the detection apparatus 10a and the detection apparatus 10b.

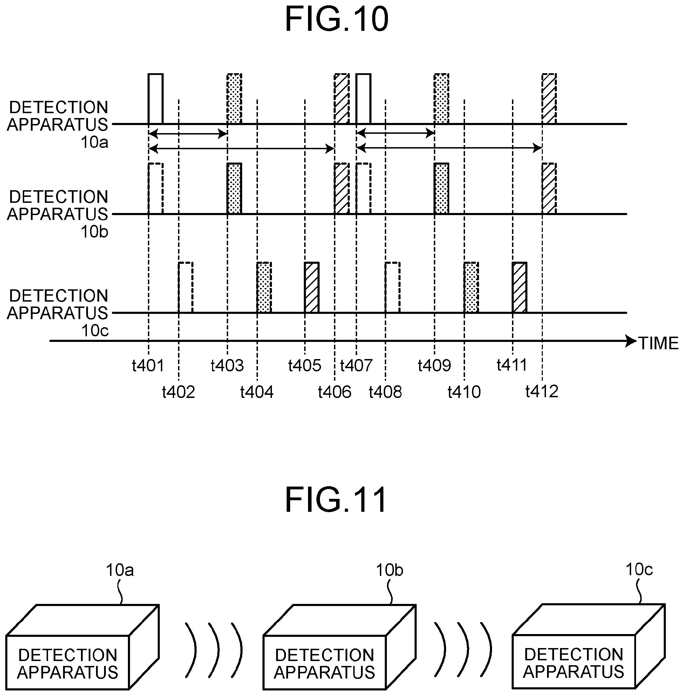

FIG. 10 is a diagram illustrating an example of operation of the detection system corresponding to the arrangement example illustrated in FIG. 9. Similarly to FIG. 8, the cycle time is set to three seconds. Further, the interval time between the detection apparatus 10a and the detection apparatus 10b is set to one second. Furthermore, the interval time between the detection apparatus 10a and the detection apparatus 10c is set to two seconds. In this case, operation is repeated such that the detection apparatus 10b generates oscillation one second after the detection apparatus 10a generates oscillation, the detection apparatus 10c generates oscillation one second after the detection apparatus 10b generates oscillation, and the detection apparatus 10a generates oscillation one second after the detection apparatus 10c generates oscillation. Meanwhile, it may be possible to adopt operation in which the detection apparatus 10a generates oscillation, and, after a lapse of the first time (for example, one second) since a time at which the detection apparatus 10b detects the oscillation that is generated by the detection apparatus 10a, the detection apparatus 10b generates oscillation and the detection apparatus 10a detects the oscillation that is generated by the detection apparatus 10b. Moreover, in this case, the detection apparatus 10c may determine an oscillation time of the detection apparatus 10c itself and generate oscillation by using information on one or both of a lapse of a second time (for example, two seconds) since detection of the oscillation that is generated by the detection apparatus 10a and a lapse of the first time since detection of the oscillation that is generated by the detection apparatus 10b. Meanwhile, the second time can be arbitrary as long as the second time is different from the first time.

As illustrated in FIG. 10, the detection apparatus 10a generates oscillation at t401. Further, the detection apparatus 10b detects, at t401, the oscillation that is generated by the detection apparatus 10a at t401. Furthermore, the detection apparatus 10c detects, at t402, the oscillation that is generated by the detection apparatus 10a at t401.

The detection apparatus 10b generates oscillation at t403. Further, the detection apparatus 10a detects, at t403, the oscillation that is generated by the detection apparatus 10b at t403. Furthermore, the detection apparatus 10c detects, at t404, the oscillation that is generated by the detection apparatus 10b at t403.

The detection apparatus 10c generates oscillation at t405. Further, the detection apparatus 10a detects, at t406, the oscillation that is generated by the detection apparatus 10c at t405. Furthermore, the detection apparatus 10b detects, at t406, the oscillation that is generated by the detection apparatus 10c at t405.

The detection apparatus 10a measures t403 - t401. When t403 - t401 is longer than the interval time with respect to the detection apparatus 10b, the detection apparatus 10a determines that the mode with respect to the detection apparatus 10b is the post-installation mode. When t403 - t401 is equal to the interval time with respect to the detection apparatus 10b, the detection apparatus 10a determines that the mode with respect to the detection apparatus 10b is the pre-installation mode.

The detection apparatus 10a measures t406 - t401. When t406 - t401 is longer than the interval time with respect to the detection apparatus 10c, the detection apparatus 10a determines that the mode with respect to the detection apparatus 10c is the post-installation mode. When t406 - t401 is equal to the interval time with respect to the detection apparatus 10c, the detection apparatus 10a determines that the mode with respect to the detection apparatus 10c is the pre-installation mode.

In the example illustrated in FIG. 10, the mode between the detection apparatus 10a and the detection apparatus 10b is the pre-installation mode. The mode between the detection apparatus 10a and the detection apparatus 10c is the post-installation mode.

Fifth arrangement example: three detection apparatuses are separated from one another

FIG. 11 is a diagram illustrating an arrangement example of the detection apparatuses. As illustrated in FIG. 11, the detection apparatus 10a, the detection apparatus 10b, and the detection apparatus 10c are separated from each other.

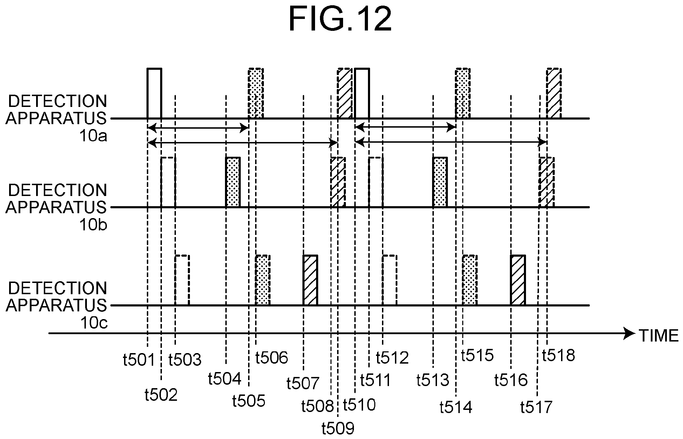

FIG. 12 is a diagram illustrating an example of operation of the detection system corresponding to the arrangement example illustrated in FIG. 11. Similarly to FIG. 8, the cycle time is set to three seconds. Further, the interval time between the detection apparatus 10a and the detection apparatus 10b is set to one second. Furthermore, the interval time between the detection apparatus 10a and the detection apparatus 10c is set to two seconds. In this case, operation is repeated such that the detection apparatus 10b generates oscillation one second after the detection apparatus 10a generates oscillation, the detection apparatus 10c generates oscillation one second after the detection apparatus 10b generates oscillation, and the detection apparatus 10a generates oscillation one second after the detection apparatus 10c generates oscillation. Meanwhile, it may be possible to adopt operation in which the detection apparatus 10a generates oscillation, and, after a lapse of the first time (for example, one second) since a time at which the detection apparatus 10b detects the oscillation that is generated by the detection apparatus 10a, the detection apparatus 10b generates oscillation and the detection apparatus 10a detects the oscillation that is generated by the detection apparatus 10b. Moreover, in this case, the detection apparatus 10c may determine an oscillation time of the detection apparatus 10c itself and generate oscillation by using information on one or both of a lapse of the second time (for example, two seconds) since detection of the oscillation that is generated by the detection apparatus 10a and a lapse of the first time since detection of the oscillation that is generated by the detection apparatus 10b.

As illustrated in FIG. 12, the detection apparatus 10a generates oscillation at t501. Further, the detection apparatus 10b detects, at t502, the oscillation that is generated by the detection apparatus 10a at t501. Furthermore, the detection apparatus 10c detects, at t503, the oscillation that is generated by the detection apparatus 10a at t501.

The detection apparatus 10b generates oscillation at t504. Further, the detection apparatus 10a detects, at t505, the oscillation that is generated by the detection apparatus 10b at t504. Furthermore, the detection apparatus 10c detects, at t506, the oscillation that is generated by the detection apparatus 10b at t504.

The detection apparatus 10c generates oscillation at t507. Further, the detection apparatus 10a detects, at t509, the oscillation that is generated by the detection apparatus 10c at t507. Furthermore, the detection apparatus 10b detects, at t508, the oscillation that is generated by the detection apparatus 10c at t507.

The detection apparatus 10a measures t505 - t501. When t505 - t501 is longer than the interval time with respect to the detection apparatus 10b, the detection apparatus 10a determines that the mode with respect to the detection apparatus 10b is the post-installation mode. When t505 - t501 is equal to the interval time with respect to the detection apparatus 10b, the detection apparatus 10a determines that the mode with respect to the detection apparatus 10b is the pre-installation mode.

The detection apparatus 10a measures t509 - t501. When t509 - t501 is longer than the interval time with respect to the detection apparatus 10c, the detection apparatus 10a determines that the mode with respect to the detection apparatus 10c is the post-installation mode. When t509 - t501 is equal to the interval time with respect to the detection apparatus 10c, the detection apparatus 10a determines that the mode with respect to the detection apparatus 10c is the pre-installation mode.

In the example illustrated in FIG. 12, the mode between the detection apparatus 10a and the detection apparatus 10b and the mode between the detection apparatus 10a and the detection apparatus 10c are the post-installation modes.

Meanwhile, when the three or more detection apparatuses 10 are present, the detection apparatuses 10 as sources of oscillation may be distinguished from one another by differentiating the frequency of the oscillation that is generated by each of the detection apparatuses 10. For example, the detection apparatus 10a generates oscillation at 1 kHz, the detection apparatus 10b generates oscillation at 2 kHz, and the detection apparatus 10c generates oscillation at 3 kHz. The oscillation receiver unit 12 is able to separate and extract oscillation at a specific frequency from the detected oscillation.

Flow of process according to first embodiment

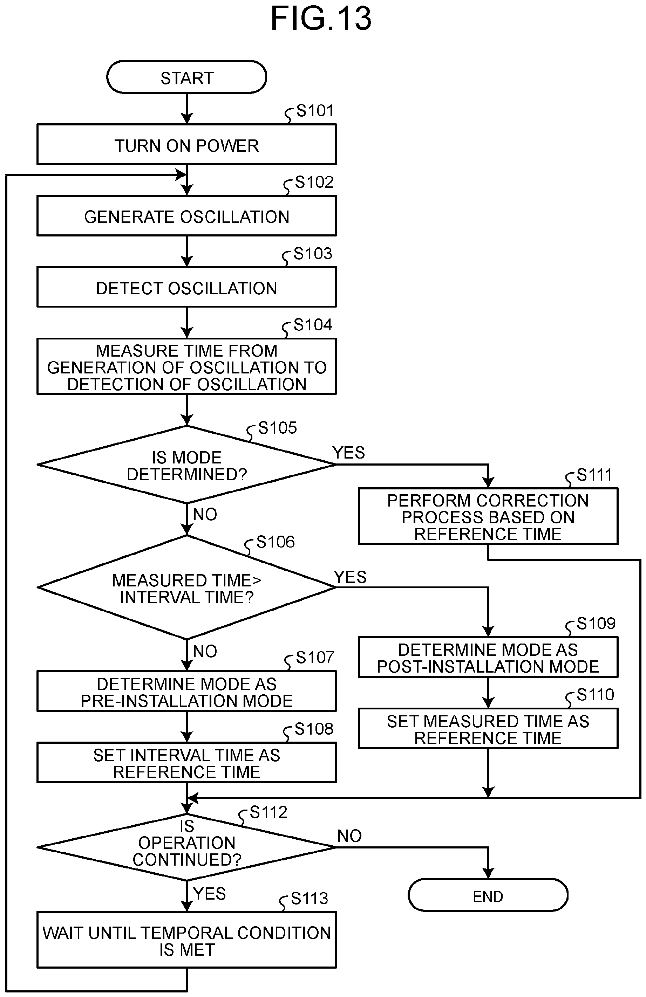

A flow of a process performed by the detection apparatus 10 will be described below with reference to FIG. 13. A flowchart illustrating the flow of the process performed by the detection apparatus according to the first embodiment is illustrated. Meanwhile, in this example, the detection system 1 includes the detection apparatus 10a and the detection apparatus 10b. However, it is assumed that the way of arrangement of the detection apparatus 10a and the detection apparatus 10b is not known. Further, it is assumed that the process in the flowchart is mainly performed by the detection apparatus 10a.

As illustrated in FIG. 1, the detection apparatus 10a starts the process when a power supply is turned on (Step S101). At this time, the mode of the detection apparatus 10a is not determined.

The detection apparatus 10a generates oscillation (Step S102). The oscillation that is generated by the detection apparatus 10a is detected by the detection apparatus 10b. The detection apparatus 10a generates oscillation every time the temporal condition is met.

Subsequently, the detection apparatus 10a detects oscillation (Step S103). The detection apparatus 10a detects oscillation that is generated by the detection apparatus 10b.

The detection apparatus 10a measures a time from generation of the oscillation to detection of the oscillation (Step S 104). Here, when the mode with respect to the detection apparatus 10b is not yet determined (Step S105, No), the detection apparatus 10a goes to Step S106. In contrast, when the mode with respect to the detection apparatus 10b is already determined (Step S105, Yes), the detection apparatus 10a goes to Step S111.

At Step S106, when the measured time is no longer than the interval time (for example, equal) (Step S106, No), the detection apparatus 10a determines the mode with respect to the detection apparatus 10b as the pre-installation mode (Step S107). Further, the detection apparatus 10a sets the interval time as the reference time (Step S108). Meanwhile, a case in which the measured time is shorter than the interval time and a case in which a user or the like gives a notice of the current mode to the detection apparatus 10a are not taken into account.

In this manner, when the measured time is no longer than the interval time, the detection apparatus 10a determines that the mode is the pre-installation mode in which the detection apparatus 10a and the detection apparatus 10b are arranged close to each other. Further, when determining that the mode is the pre-installation mode, the detection apparatus 10a sets the interval time as the reference time, and determines whether or not to perform correction of deviation of the internal clocks of the detection apparatus 10a and the detection apparatus 10b based on a difference between a time that is measured after the reference time is set and the reference time. With this configuration, the detection apparatus 10a is able to correct the internal clocks in the pre-installation mode before operation.

Meanwhile, when determining that the mode is the pre-installation mode, the detection apparatus 10a may set the reference time to a time that is obtained by adding, to the interval time, a time (minimum propagation time) that is taken by the oscillation to propagate between the detection apparatus 10a and the detection apparatus 10b that are arranged close to each other, and determine whether or not to perform correction of deviation of the internal clocks of the detection apparatus 10a and the detection apparatus 10b based on a difference between a time that is measured after the reference time is set and the reference time. With this configuration, the detection apparatus 10a is able to more accurately determine the mode while taking into account the minimum propagation time.

At Step S106, when the measured time is longer than the interval time (Step S106, Yes), the detection apparatus 10a determines the mode with respect to the detection apparatus 10b as the post-installation mode (Step S109). Further, the detection apparatus 10a sets the measured time as the reference time (Step S110).

In this manner, when the measured time is longer than the interval time, the detection apparatus 10a determines that the mode is the post-installation mode in which the detection apparatus 10a and the detection apparatus 10b are arranged separately from each other. Further, when determining that the mode is the post-installation mode, the detection apparatus 10a sets the measured time as the reference time, and determines whether or not to perform correction of deviation of the internal clocks of the detection apparatus 10a and the detection apparatus 10b based on a difference between a time that is measured after the reference time is set and the reference time. With this configuration, the detection apparatus 10a is able to correct the internal clocks even when operation is being performed in the post-installation mode.

Furthermore, at Step S111, the detection apparatus 10a performs a correction process based on the reference time (Step S111). In the correction process, the detection apparatus 10a determines whether or not the internal clocks deviate by comparing the measured time and the reference time, and corrects the internal clocks when determining that the internal clocks deviate.

For example, when a difference between the measured time and the reference time is equal to or larger than a threshold, the detection apparatus 10a determines that deviation of the internal clocks of the detection apparatus 10a and the detection apparatus 10b are to be corrected. With this configuration, the detection apparatus 10a is able to take into account, by the threshold, an error between the measured time and the reference time.

At Step S112, when the operation is continued (Step S112, Yes), the detection apparatus 10a waits until the temporal condition is met (Step S113), returns to Step S102, and repeats the process.

When the operation is not continued (Step S112, No), the detection apparatus 10a terminates the process. For example, when a shutdown process is started or when a process termination command is explicitly received, the detection apparatus 10a does not continue the operation.

At Step S106, the detection apparatus 10a may perform determination on a mid-installation mode, separately from the determination on the pre-installation mode and the post-installation mode. When determining that the mode is the mid-installation mode, the detection apparatus 10a returns to Step S102, and continuously performs determination on the mode.

A method for determination on the mid-installation mode will be described below. However, the method for determination on the mid-installation mode is not limited to the method as described below. First, the detection apparatus 10a checks whether a frequency of the detected oscillation is the smallest among oscillation that is detected after the power supply is turned on. When the frequency is not the smallest, the detection apparatus 10a returns to Step S102.

Further, when the detected oscillation is the oscillation at the smallest frequency, the detection apparatus 10a calculates variation of a predetermined number of times that were measured in the past. When the variation is larger than a threshold, the detection apparatus 10a determines that the position of the detection apparatus 10a or the detection apparatus 10b is not determined, that is, the mode is the mid-installation mode.

First Example

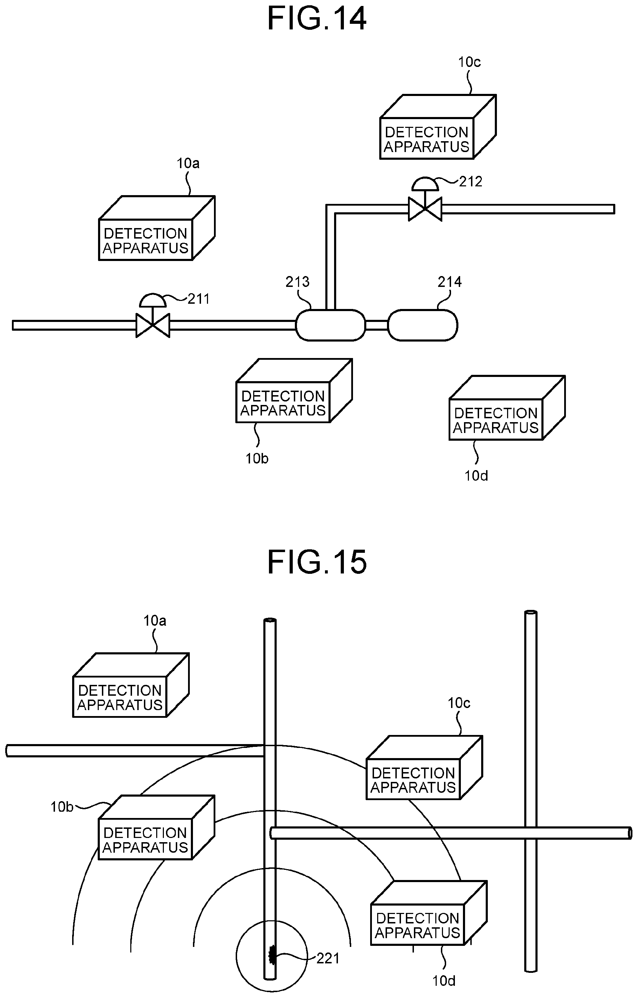

Examples of the detection system 1 will be described. FIG. 14 is a diagram for explaining a first example. As illustrated in FIG. 14, the detection system 1 is arranged in a facility that includes a valve 211, a valve 212, a pump 213, and a motor 214.

For example, the detection apparatus 10a strongly collects process (fluid) sound of the pump 213. Further, the detection apparatus 10b strongly collects sound of the pump 213. Furthermore, the detection apparatus 10d strongly collects sound of the motor 214. In this manner, each of the detection apparatuses 10 strongly collects sound that is generated nearby.

If times are correctly synchronized, it is possible to emphasize the sound of the process by subtracting the sound that is collected by the detection apparatus 10b from the sound that is collected by the detection apparatus 10a. Further, the detection system 1 is able to identify a position of a sound source by performing beam forming based on the sound that is collected by each of the detection apparatuses 10.

Second Example

FIG. 15 is a diagram for explaining a second example. A magnitude of the sound that is detected by each of the detection apparatuses 10 varies depending on closeness to a sound source 221 in FIG. 5. The detection system 1 is able to identify a position of the sound source 221 based on distances from the plurality of detection apparatuses 10. Furthermore, if the detection apparatus 10 is able to detect sound directivity, the detection system 1 is able to more accurately identify the position of the sound source 221.

Third Example

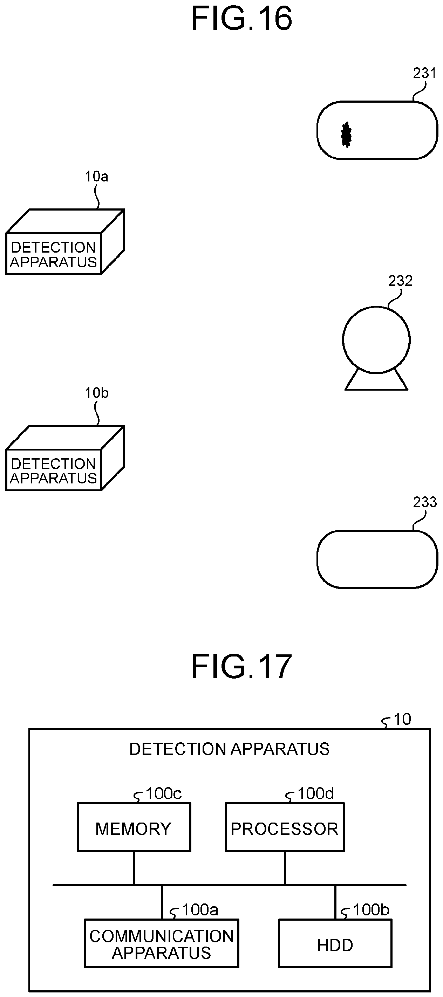

FIG. 16 is a diagram for explaining a third example. As illustrated in FIG. 16, each of the detection apparatuses 10 may detect sound from a plurality of sound sources. For example, it is possible to distinguish between sound of a motor 231, a pump 232, and a tank 233 based on the sound that is detected by the detection apparatus 10a and the detection apparatus 10b and a time lag. Further, by distinguishing the sound, it is possible to identify a place at which abnormal sound has occurred. In other words, in the third example, it is possible to perform beam forming.

Method of correcting internal clock

The detection apparatus 10a is able to correct the internal clock in accordance with the procedure below. Meanwhile, in this example, the pre-installation mode in which the detection apparatus 10a and the detection apparatus 10b are arranged close to each other is adopted.

First, the detection apparatus 10a generates oscillation when the internal clock of the subject apparatus indicates a time 0:00:00.00 (here, hours: minutes: seconds). Further, the detection apparatus 10b generates oscillation when the internal clock of the subject apparatus indicates a time 0:00:00.00.

Furthermore, the detection apparatus 10a generates oscillation when the internal clock of the subject apparatus indicates a time 1 :00:00.00 that indicates a lapse of one hour. Moreover, the detection apparatus 10b detects oscillation when the internal clock of the subject apparatus indicates a time 1:00:00.31. This indicates that the internal clocks of the detection apparatus 10a and the detection apparatus 10b relatively deviate by 0:00:00.30 in one hour (60 minutes).

Therefore, from now on, the detection apparatus 10a adds 0:00:00.01 to the internal clock of the subject apparatus every two minutes, for example. Alternatively, the detection apparatus 10b subtracts 0:00:00.01 from the internal clock of the subject apparatus every two minutes. The detection apparatus 10 may perform correction (addition and subtraction) with high frequency or low frequency, instead of two minutes. Furthermore, the detection apparatus 10 may perform the correction by adjusting a clock of a crystal oscillator by adjustment of voltage or the like, or by changing a division ratio of the clock of the crystal oscillator. For example, addition and subtraction with respect to the internal clock may be performed by adjusting a clock time of the crystal oscillator. The detection apparatus 10 is able to perform addition and subtraction with a detailed order by performing the correction with high frequency (for example, every one millisecond). For example, the detection apparatus 10 is able to perform addition in units of microseconds (μ), such as 100 μs + 1 μs, by software processing.

In this mode, the detection apparatuses are located in the same place, and therefore, a condition, such as temperature, is the same. Therefore, deviation of the internal clock depends on individual differences of crystal oscillators or oscillation circuits, and the individual differences are recognized and corrected. In contrast, in the post-installation mode, the detection apparatuses are installed in different places, and therefore, in some cases, temperature or the like may be different between the detection apparatuses. Time deviation occurs due to a temperature difference or the like, and therefore, the time is periodically corrected in the post-installation mode. It may be possible to estimate a surrounding environment, such as temperature, from the correction information.

Here, when the determination unit 141 determines that the mode is the pre-installation mode, the correction unit 143 records first deviation between a first internal clock and a second internal clock based on a difference between the time that is measured by the measurement unit 142 and the reference time, and, when the determination unit 141 determines that the mode is the post-installation mode, the correction unit 143 records second deviation between the first internal clock and the second internal clock based on a difference between the time that is measured by the measurement unit 142 and the reference time. For example, the correction unit 143 calculates the first deviation and the second deviation, and stores the first deviation and the second deviation in the storage unit 15 together with timestamps. The first deviation may occur due to individual differences of oscillation circuits, such as crystal oscillators. Further, the second deviation may occur due to surrounding environments (for example, temperature) of the detection apparatuses 10. Therefore, by comparing the first deviation and the second deviation, it is possible to estimate a change in the surrounding environments between the pre-installation mode and the post-installation mode of the detection apparatus 10. For example, with an increase in the first deviation and the second deviation, a temperature difference in surrounding environments between the pre-installation mode and the post-installation mode of the detection apparatus 10 increases.

System

The processing procedures, control procedures, specific names, and information including various kinds of data and parameters illustrated in the above-described document and drawings may be arbitrarily changed unless otherwise specified.

Furthermore, the components of the apparatuses illustrated in the drawings are functionally conceptual and do not necessarily have to be physically configured in the manner illustrated in the drawings. In other words, specific forms of distribution and integration of the apparatuses are not limited to those illustrated in the drawings. That is, all or part of the apparatuses may be functionally or physically distributed or integrated in arbitrary units depending on various loads or use conditions.

Moreover, all or an arbitrary part of processing functions that are implemented by the apparatuses may be realized by a CPU and a program analyzed and executed by the CPU, or may be realized by hardware using wired logic.

Hardware

A hardware configuration example of the detection apparatus 10 will be described below. FIG. 17 is a diagram for explaining the hardware configuration example.

As illustrated in FIG. 17, the detection apparatus 10 includes a communication apparatus 100a, an HDD 100b, a memory 100c, and a processor 100d. Further, the units illustrated in FIG. 17 are connected to one another via a bus or the like.

The communication apparatus 100a is a network interface card or the like, and performs communication with a different apparatus. The HDD 100b stores therein a program and a database (DB) for operating the functions as illustrated in FIG. 2.

The processor 100d reads a program that executes the same processes as those of each of the processing units illustrated in FIG. 2 from the HDD 100b or the like, loads the program onto the memory 100c, and operates processes for implementing each of the functions as described above with reference to FIG. 2 or the like. For example, the processes execute the same functions as those of the processing units included in the detection apparatus 10. Specifically, the processor 100d reads, from the HDD 100b or the like, a program that has the same functions as those of the determination unit 141, the measurement unit 142, and the correction unit 143. Further, the processor 100d executes a process that implements the same processes as those of the determination unit 141, the measurement unit 142, and the correction unit 143.

In this manner, by reading and executing the program, the detection apparatus 10 operates as a detection apparatus that implements a time synchronization method. Further, the detection apparatus 10 may be able to implement the same functions as those of the examples as described above by causing a medium reading apparatus to read the above-described program from a recording medium and executing the read program. Meanwhile, the program described in this example need not always be executed by the detection apparatus 10. For example, the present invention may be applied in the same manner to a case in which a different computer or a server executes the program and a case in which the different computer and the server execute the program in a cooperative manner.

The program may be distributed via a network, such as the Internet. Further, the program may be recorded in a computer readable recording medium, such as a hard disk, a flexible disk (FD), a compact disk read only memory (CD-ROM), a Magneto-Optical disk (MO), or a Digital Versatile Disc (DVD), and executed by being read from the recording medium by the computer.

Some examples of combinations of disclosed technical features will be described below.

According to one embodiment, it is possible to synchronize times while taking into account a positional relationship among a plurality of sensors.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

**Claims**

1.  A detection apparatus (10) comprising:

    an internal clock;
    an oscillator unit (11) that generates oscillation every time a temporal condition is met;
    an oscillation receiver unit (11) that detects oscillation;
    a measurement unit (142) that measures a time from when the oscillator unit (11) generates the oscillation to when the oscillation receiver unit (11) detects the oscillation;
    a determination unit (141) that determines a mode based on whether the time that is measured by the measurement unit (142) is longer than a predetermined interval time; and
    a correction unit (143) that determines whether to perform correction of deviation of the internal clock based on a reference time when it is determined that the mode is a specific mode, and corrects the internal clock when determining that the correction is performed.

2.  A time synchronization method that is implemented by a detection apparatus (10) including:

    an internal clock;
    an oscillator unit (11) that generates oscillation every time a temporal condition is met; and
    an oscillation receiver unit (11) that detects oscillation, the time synchronization method comprising:

    measuring a time from when the oscillator unit (11) generates the oscillation to when the oscillation receiver unit (11) detects the oscillation;
    determining a mode based on whether the time that is measured at the measuring is longer than a predetermined interval time;
    determining whether to perform correction of deviation of the internal clock when it is determined that the mode is a specific mode; and
    correcting the internal clock when determining that the correction is performed.

3.  A time synchronization program that causes a detection apparatus (10) including:

    an internal clock;
    an oscillator unit (11) that generates oscillation every time a temporal condition is met; and
    an oscillation receiver unit (11) that detects oscillation, to perform a process comprising:

    measuring a time from when the oscillator unit (11) generates the oscillation to when the oscillation receiver unit (11) detects the oscillation;
    determining a mode based on whether the time that is measured at the measuring is longer than a predetermined interval time;
    determining whether to perform correction of deviation of the internal clock when it is determined that the mode is a specific mode; and
    correcting the internal clock when determining that the correction is performed.

4. A detection system comprising:

   a first detection apparatus (10) that includes a first internal clock; and
   a second detection apparatus (10) that includes a second internal clock, wherein
   the first detection apparatus (10) further includes:

      a first oscillator unit (11) that generates oscillation every time a temporal condition is met;
      a first oscillation receiver unit (11) that detects oscillation that is generated by the second detection apparatus (10);
      a measurement unit (142) that measures a time from when the first oscillator unit (11) generates the oscillation to when the first oscillation receiver unit (11) detects the oscillation;
      a determination unit (141) that determines a mode based on whether the time that is measured by the measurement unit (142) is longer than a predetermined interval time; and
      a correction unit (143) that determines whether to perform correction of deviation between the first internal clock and the second internal clock based on a reference time when it is determined that the mode is a specific mode, and corrects one of the first internal clock and the second internal clock when determining that the correction is performed, and

   the second detection apparatus (10) further includes:
   a second oscillator unit (11) that generates oscillation every time a temporal condition is met.

5. The detection system according to claim 4, wherein the determination unit (141) determines that the mode is a pre-installation mode in which the first detection apparatus (10) and the second detection apparatus (10) are arranged close to each other when the time that is measured by the measurement unit (142) is no longer than the interval time.

6. The detection system according to claim 5, wherein
   the correction unit (143) sets the interval time as the reference time when the determination unit (141) determines that the mode is the pre-installation mode, and determines whether to perform correction of the deviation between the first internal clock and the second internal clock based on a difference between a time that is measured by the measurement unit (142) after the reference time is set and the reference time.

7. The detection system according to claim 5, wherein
   when the determination unit (141) determines that the mode is the pre-installation mode, the correction unit (143) sets, as the reference time, a time that is obtained by adding, to the interval time, a time that is taken by oscillation to propagate between the first detection apparatus (10) and the second detection apparatus (10) that are arranged close to each other, and determines whether to perform correction of the deviation between the first internal clock and the second internal clock based on a different between a time that is measured by the measurement unit (142) after the reference time is set and the reference time.

8. The detection system according to claim 4, wherein when the time that is measured by the measurement unit (142) is longer than the interval time, the determination unit (141) determines that the mode is a post-installation mode in which the first detection apparatus (10) and the second detection apparatus (10) are arranged separately from each other.

9. The detection system according to claim 8, wherein when the determination unit (141) determines that the mode is the post-installation mode, the correction unit (143) sets a time that is measured by the measurement unit (142) as the reference time, and determines whether to perform correction of the deviation between the first internal clock and the second internal clock based on a difference between a time that is measured by the measurement unit (142) after the reference time is set and the reference time.

10. The detection system according to claim 4, wherein when a difference between the time that is measured by the measurement unit (142) and the reference time is equal to or larger than a threshold, the determination unit (141) determines that the correction of the deviation between the first internal clock and the second internal clock is performed.

11. The detection system according to claim 4, wherein

    when the determination unit (141) determines that the mode is the pre-installation mode, the correction unit (143) records first deviation between the first internal clock and the second internal clock based on a difference between a time that is measured by the measurement unit (142) and the reference time, and

when the determination unit (141) determines that the mode is the post-installation mode, the correction unit (143) records second deviation between the first internal clock and the second internal clock based on a difference between a time that is measured by the measurement unit (142) and the reference time.

# FIG.1

# FIG.2

DETECTION APPARATUS 〔10

CONTROL UNIT 〔14

STORAGE UNIT 〔15

OSCILLATOR UNIT 〔11

OSCILLATION RECEIVER UNIT 〔12

CLOCK UNIT 〔13

DETERMINATION UNIT 〔141

MEASUREMENT UNIT 〔142

CORRECTION UNIT 〔143

INTERVAL INFORMATION 〔151

# FIG.3

10a DETECTION APPARATUS

10b DETECTION APPARATUS

# FIG.4

GENERATION

DETECTION
APPARATUS
10a

DETECTION

DETECTION
APPARATUS
10b

TIME

t101        t102        t103

# FIG.5

10a

DETECTION
APPARATUS

10b

DETECTION
APPARATUS

# FIG.6

DETECTION
APPARATUS
10a

DETECTION
APPARATUS
10b

TIME

t201  t202          t203  t204          t205  t206

# FIG.7

10a— DETECTION APPARATUS

10b— DETECTION APPARATUS

10c— DETECTION APPARATUS

# FIG.8

DETECTION
APPARATUS
10a

DETECTION
APPARATUS
10b

DETECTION
APPARATUS
10c

TIME

t301    t302    t303  t304    t305    t306

# FIG.9

10c

10a — DETECTION
APPARATUS

10b — DETECTION
APPARATUS

DETECTION
APPARATUS

# FIG.10

# FIG.11

# FIG.12

# FIG.13

START

S101
TURN ON POWER

S102
GENERATE OSCILLATION

S103
DETECT OSCILLATION

S104
MEASURE TIME FROM GENERATION OF OSCILLATION TO DETECTION OF OSCILLATION

S105
IS MODE DETERMINED? — YES →

S111
PERFORM CORRECTION PROCESS BASED ON REFERENCE TIME

NO

S106
MEASURED TIME> INTERVAL TIME? — YES →

S109
DETERMINE MODE AS POST-INSTALLATION MODE

S110
SET MEASURED TIME AS REFERENCE TIME

NO

S107
DETERMINE MODE AS PRE-INSTALLATION MODE

S108
SET INTERVAL TIME AS REFERENCE TIME

S112
IS OPERATION CONTINUED? — NO →

END

YES

S113
WAIT UNTIL TEMPORAL CONDITION IS MET

# FIG.14

# FIG.15

# FIG.16

231

10a

DETECTION APPARATUS

232

10b

DETECTION APPARATUS

233

# FIG.17

10

## DETECTION APPARATUS

100c
MEMORY

100d
PROCESSOR

100a
COMMUNICATION APPARATUS

100b
HDD

# EUROPEAN SEARCH REPORT

**Application Number**

EP 24 21 7050

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | JP 2017 096651 A (NEC CORP) 1 June 2017 (2017-06-01) * paragraph [0011] - paragraph [0035]; figures * | 1-11 | INV. G06F1/12 G01H1/00 G04G7/00 |
| A | DE 10 2019 218994 A1 (SIEMENS AG [DE]) 4 March 2021 (2021-03-04) * paragraph [0039] - paragraph [0057]; figures 1-4 * | 1-11 | |
| A | EP 4 249 865 A1 (JTEKT CORP [JP]) 27 September 2023 (2023-09-27) * paragraph [0033] - paragraph [0038]; figures 1,2 * | 1-11 | |
| A | US 2018/340803 A1 (IMOKAWA TADASHI [JP] ET AL) 29 November 2018 (2018-11-29) * paragraph [0005] - paragraph [0008] * * paragraph [0031] - paragraph [0045]; figures 1-3 * | 1-11 | |
| A | JP 2007 174330 A (ATR ADVANCED TELECOMM RES INST) 5 July 2007 (2007-07-05) * the whole document * | 1-11 | TECHNICAL FIELDS SEARCHED (IPC) G06F G01H G04G G04D G04F G04C |

The present search report has been drawn up for all claims

| Place of search | Date of completion of the search | Examiner |
|---|---|---|
| The Hague | 9 April 2025 | Pascual Vallés, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**

EP 24 21 7050

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2025

| Patent document cited in search report | Publication date | Patent family member(s) | | Publication date |
|---|---|---|---|---|
| JP 2017096651 A | 01-06-2017 | JP | 6610939 B2 | 27-11-2019 |
| | | JP | 2017096651 A | 01-06-2017 |
| DE 102019218994 A1 | 04-03-2021 | NONE | | |
| EP 4249865 A1 | 27-09-2023 | CN | 116529569 A | 01-08-2023 |
| | | EP | 4249865 A1 | 27-09-2023 |
| | | JP | 7559521 B2 | 02-10-2024 |
| | | JP | 2022081152 A | 31-05-2022 |
| | | US | 2023408328 A1 | 21-12-2023 |
| | | WO | 2022107507 A1 | 27-05-2022 |
| US 2018340803 A1 | 29-11-2018 | EP | 3416291 A2 | 19-12-2018 |
| | | US | 2018340803 A1 | 29-11-2018 |
| JP 2007174330 A | 05-07-2007 | JP | 4512775 B2 | 28-07-2010 |
| | | JP | 2007174330 A | 05-07-2007 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017096651 A